# EUROPÄISCHE PATENTANMELDUNG

(11) **EP 0 899 745 A2**
(43) Veröffentlichungstag der Anmeldung: **03.03.1999**
(21) Anmeldenummer: 98115324.0
(22) Anmeldetag: 13.08.1998
(51) Int. Cl.: G11C 17/14

(54) **Fuse-Anordnung für Halbleiterspeichervorrichtung**

(30) Priorität: 28.08.1997 DE 19737611
(71) Anmelder: SIEMENS AKTIENGESELLSCHAFT, 80333 München (DE)
(72) Erfinder: Goebel, Holger, 80802 München (DE); Krause, Gunnar, 81541 München (DE)

(57) **Zusammenfassung**

Die Erfindung betrifft eine Fuse-Anordnung für eine Halbleiterspeichervorrichtung, mit einer Vielzahl von Fuses (1), die auf einem Halbleiterkörper vorgesehen und jeweils einzeln durch Energieeinwirkung zur Unterbrechung einer leitenden Verbindung programmierbar sind. Zur Einsparung von Chipfläche sind die Fuses (1) in wenigstens zwei Ebenen (2, 3) übereinander vorgesehen.

## Beschreibung

Die vorliegende Erfindung betrifft eine Fuse-Anordnung für eine Halbleiterspeichervorrichtung, mit einer Vielzahl von Fuses, die auf einem Halbleiterkörper vorgesehen und jeweils einzeln durch Energieeinwirkung zur Unterbrechung oder Herstellung einer leitenden Verbindung programmierbar sind.

Fuses werden bekanntlich zur permanenten Speicherung von Daten in Halbleiterspeichervorrichtungen und zur Programmierung der Redundanz in solchen Halbleiterspeichervorrichtungen verwendet. Im ersten Fall legt der Zustand der Fuse ("leitend" oder "nicht-leitend") eine Datengröße ("0" oder "1") fest, wahrend im letzteren Fall bei einer fehlerhaften Speicherzelle durch Aktivierung der Fuse eine redundante Speicherzelle zugeschaltet wird.

Fuses bestehen im allgemeinen aus beispielsweise polykristallinem Silizium oder einem anderen geeigneten Material, das durch Einwirkung von Energie geschmolzen werden kann, wodurch eine zuvor bestehende leitende Verbindung unterbrochen wird. Es ist aber auch denkbar, ein Material einzusetzen, das durch Energieeinwirkung aus dem nicht-leitenden in den leitenden Zustand überführt wird, um so eine leitende Verbindung aufzubauen. Im folgenden soll jedoch davon ausgegangen werden, daß durch die Energieeinwirkung eine bisher bestehende leitende Verbindung zerstört wird.

Die Energieeinwirkung kann beispielsweise durch Einstrahlung eines Laserstrahles auf eine Fuse oder auch einfach dadurch erfolgen, daß ein relativ großer Strom durch eine bestimmte Fuse geschickt wird, um diese zum Schmelzen zu bringen.

Bisherige Fuse-Anordnungen verwenden Fuses, die auf der Oberfläche des Halbleiterkörpers bzw. Chips einer Halbleiterspeichervorrichtung nebeneinander beispielsweise in der Art einer Matrix angeordnet sind. Mit zunehmender Anzahl der Fuses, also mit steigender Speicherkapazität der Halbleiterspeichervorrichtung, wird damit die benötigte Fläche des Chips insgesamt immer größer.

Um nun diese benötigte Fläche möglichst klein zu halten, wird bisher versucht, die Fuses geometrisch so klein als möglich zu gestalten. Dieses Vorgehen hat aber seine Grenze darin, daß beim Aktivieren bzw. Programmieren der Fuses, also beispielsweise beim Bestrahlen der Fuses mit einem Laserstrahl, ein Mindestabstand der einzelnen Fuses voneinander eingehalten werden muß, damit durch den Laserstrahl gezielt und sicher die gewünschte Fuse zum Schmelzen gebracht werden kann.

Es ist daher Aufgabe der vorliegenden Erfindung, eine FuseAnordnung zu schaffen, die sich durch einen erheblich reduzierten Platzbedarf auszeichnet und bei der dennoch einzelne Fuses gezielt und zuverlässig aktiviert werden können.

Diese Aufgabe wird bei einer Fuse-Anordnung der eingangs genannten Art erfindungsgemäß dadurch gelöst, daß die Fuses in wenigstens zwei Ebenen auf dem Halbleiterkörper vorgesehen sind. Die Fuses werden also in mehreren, beispielsweise n Ebenen übereinander angeordnet. Dadurch wird die durch die Fuses benötigte Fläche auf dem Halbleiterkörper näherungsweise um den Faktor n verringert, wenn von der Anschlußverdrahtung der Fuses abgesehen wird.

Die verschiedenen Ebenen der Fuses werden durch jeweils eine Isolierschicht aus beispielsweise Siliziumdioxid voneinander getrennt. Für die Fuses selbst wird beispielsweise polykristallines Silizium verwendet, das durch Stromfluß oder durch überlagerte Einwirkung von wenigstens zwei Laserstrahlen zum Schmelzen gebracht werden kann, um so die Fuse zu aktivieren. Die beiden einwirkenden Laserstrahlen kreuzen sich dann in der zu aktivierenden Fuse.

Bei der Erfindung sind also die Fuses in mehreren Ebenen an-geordnet, die durch eine Isolierschicht voneinander getrennt sind. Das Programmieren der Fuses erfolgt normalerweise durch einen Laserstrahl, mit dem das Fusematerial geschmolzen und damit die leitende Verbindung unterbrochen wird.

Im Fall mehrerer, übereinanderliegender Fuse-Ebenen, können die Fuses entweder durch einen definierten Strom, der das Material zum Schmelzen bringt, oder aber durch die Überlagerung mehrerer Laserstrahlen programmiert werden. Die Intensität der Laserstrahlen ist dabei so zu wählen, daß ein einzelner Strahl das Material noch nicht schädigt; durch Überlagerung mehrerer Strahlen in einen Punkt (dort wo die zu programmierende Fuse sitzt), wird die Intensität jedoch so hoch, daß die Fuse zerstört wird.

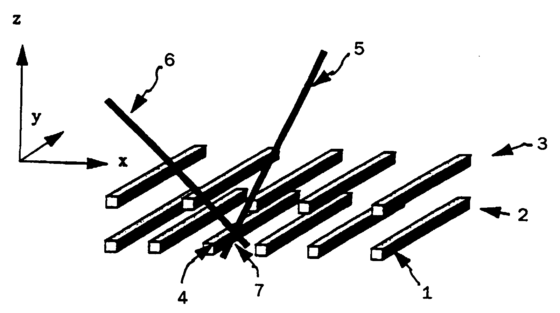

Nachfolgend wird die Erfindung anhand der Zeichnung näher erläutert, in deren einziger Figur eine Fuse-Anordnung in zwei Ebenen gezeigt ist, wobei zur besseren Darstellung dieser beiden Ebenen die zu trennende Isolierschicht weggelassen ist.

In der Figur sind Fuses 1 aus polykristallinem Silizium in zwei Ebenen 2, 3 übereinander in z-Richtung auf einer sich in einer x-y-Ebene erstreckenden Oberfläche eines nicht gezeigten Halbleiterkörpers angeordnet und voneinander durch eine ebenfalls nicht gezeigte Isolierschicht aus Siliziumdioxid getrennt.

Eine zu programmierende Fuse 4 wird zwei Laserstrahlen 5, 6 ausgesetzt, die sich in einem Punkt 7 im Bereich der Fuse 4 kreuzen, so daß diese dort zum Schmelzen gebracht und damit unterbrochen wird. Die Energie der Laserstrahlen 5, 6 ist dabei so eingestellt, daß ein Strahl allein noch kein Schmelzen hervorruft, so daß gewährleistet ist, daß gezielt nur die Fuse 4 zerstört wird, in der sich die Laserstrahlen 5, 6 kreuzen, während die übrigen Fuses 1 unbeschädigt bleiben.

Anstelle der sich kreuzenden Laserstrahlen 5, 6 kann auch durch die Fuse 4 ein solcher Strom geschickt werden, daß diese Fuse 4 zum Schmelzen gebracht und damit zerstört wird.

## Patentansprüche

1. Fuse-Anordnung für Halbleiterspeichervorrichtung, mit einer Vielzahl von Fuses (1), die auf einem Halbleiterkörper vorgesehen und jeweils einzeln durch Energieeinwirkung zur Unterbrechung oder Herstellung einer leitenden Verbindung programmierbar sind,
dadurch gekennzeichnet, daß
die Fuses (1) in wenigstens zwei Ebenen (2, 3) auf dem Halbleiterkörper vorgesehen und jeweils durch überlagerte Einwirkung (7) von wenigstens zwei Laserstrahlen (5, 6) programmierbar sind, wobei die überlagerten Laserstrahlen (5, 6) sich in einer zu programmierenden Fuse (4) kreuzen.

2. Fuse-Anordnung nach Anspruch 1, dadurch gekennzeichnet, daß die Ebenen (2, 3) der Fuses (1) durch eine Isolierschicht voneinander getrennt sind.

3. Fuse-Anordnung nach Anspruch 2, dadurch gekennzeichnet, daß die Isolierschicht aus Siliziumdioxid besteht.

4. Fuse-Anordnung nach einem der Ansprüche 1 bis 3, dadurch gekennzeichnet, daß die Fuses (1) aus polykristallinem Silizium bestehen.
